(19) **Europäisches Patentamt**
**European Patent Office**
**Office européen des brevets**

(11) **EP 1 217 629 B1**

(12) **FASCICULE DE BREVET EUROPEEN**

(45) Date de publication et mention
de la délivrance du brevet:
**25.07.2007 Bulletin 2007/30**

(51) Int Cl.:
*G11C 27/02* $^{(2006.01)}$    *G11C 8/04* $^{(2006.01)}$

(21) Numéro de dépôt: **01403322.9**

(22) Date de dépôt: **20.12.2001**

(54) **Procédé d'acquisition par échantillonnage de signaux analogiques et système d'acquisition pour la mise en oeuvre de ce procédé**

Abtasterfassungverfahren analoger Signale und dazugehöriges Erfassungssystem

Analog signal sampling acquisition process and acquisition system therefor

(84) Etats contractants désignés:
**AT BE CH CY DE DK ES FI FR GB GR IE IT LI LU MC NL PT SE TR**

(30) Priorité: **20.12.2000 FR 0016678**

(43) Date de publication de la demande:
**26.06.2002 Bulletin 2002/26**

(73) Titulaire: **CHAUVIN ARNOUX**
**75018 Paris (FR)**

(72) Inventeur: **Arnoux, Daniel**
**75018 Paris (FR)**

(74) Mandataire: **Berger, Helmut**
**Cabinet WEINSTEIN**
**56 A, rue du Faubourg Saint-Honoré**
**75008 Paris (FR)**

(56) Documents cités:
**US-A- 4 271 488       US-A- 5 526 286**

• **PATENT ABSTRACTS OF JAPAN vol. 2000, no. 01, 31 janvier 2000 (2000-01-31) & JP 11 283394 A (ROHM CO LTD), 15 octobre 1999 (1999-10-15)**

**Description**

L'invention concerne un système d'acquisition par échantillonnage de signaux analogiques tel que défini dans le préambule de la revendication 1.

De tels systèmes d'échantillonnage sont connus notamment par le document américain US-A-4 271 488.

Il s'avère qu'ils présentent l'inconvénient d'un niveau de bruit trop élevé et par conséquent des rapports signal utile/bruit relativement faibles.

La présente invention a pour but de proposer un système d'acquisition d'un signal analogique par échantillonnage, qui élimine l'inconvénient susmentionné.

A cet effet, le système d'acquisition selon l'invention est défini conformément à la partie caractérisante de la revendication 1.

Certes, on connaît du document japonais JP 11 283 394 un circuit d'échantillonnage qui permet d'avoir une réduction des tensions d'erreur et une augmentation de la précision d'échantillonnage grâce au dédoublement des cellules mémoires constituant le circuit, lesdites cellules recevant des signaux en opposition de phase. Le circuit comprend six interrupteurs commandés.

Une combinaison du document japonais et du document américain amènerait à remplacer dans la matrice du document américain chaque élément de mémoire par le circuit du document japonais comportant les six interrupteurs.

Ni le document américain ni le document japonais n'indique comment il faut alors réaliser la commande d'un tel élément.

Par conséquent, la partie caractérisante ne découle pas de façon évidente de l'état de la technique.

D'autres caractéristiques font les objets des revendications dépendantes.

L'invention sera mieux comprise, et d'autre buts, caractéristiques, détails et avantages de celle-ci apparaîtront plus clairement dans la description explicative qui va suivre faite en référence aux dessins schématiques annexés donnés uniquement à titre d'exemple illustrant un mode de réalisation de l'invention et dans lesquels :

- La figure 1 montre schématiquement un système d'acquisition d'un signal analogique par échantillonnage, selon l'invention, comportant deux matrices mémoire ; et
- La figure 2 montre schématiquement la structure d'une cellule mémoire selon la présente invention ;

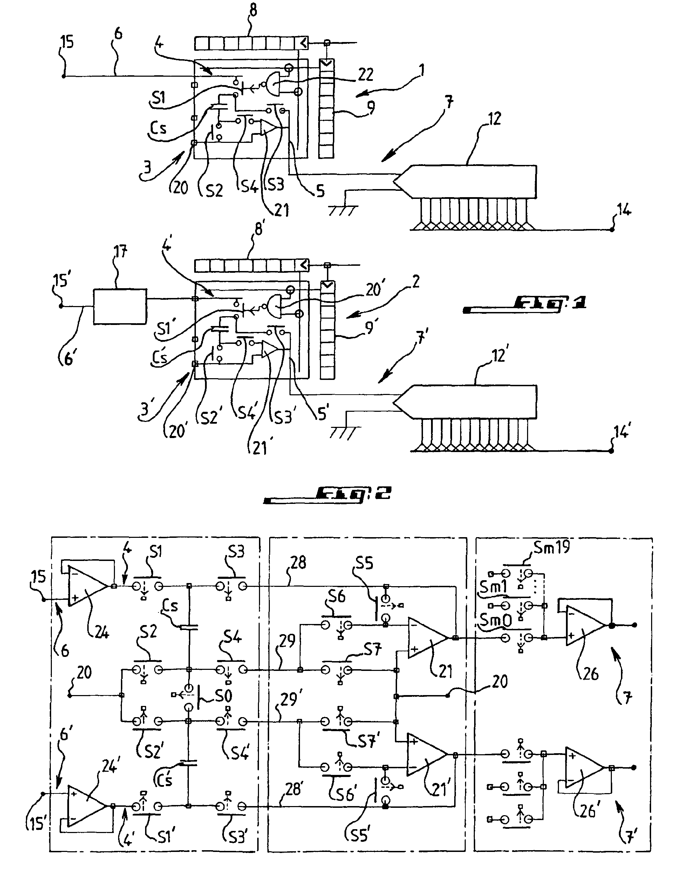

La figure 1 montre schématiquement qu'un système d'acquisition de signaux analogiques, par échantillonnage, selon l'invention est issu d'une combinaison de deux structures d'échantillonnage individuelles comportant chacune une matrice de cellules mémoire analogique 1, 2 agencées en lignes et en colonnes dont seulement une cellule est représentée en 3, 3'. Chaque cellule est reliée, de façon connue en soi, à un bus d'écriture 4 et un bus de lecture 5 reliés respectivement à un circuit d'entrée 6 et un circuit de sortie 7, pour la matrice 1, et 4', 5', 6', 7' pour la matrice 2. Egalement d'une manière connue en soi, chaque cellule est activable pour l'écriture d'un échantillon du signal analogique et la lecture de cet échantillon par deux signaux de commande en provenance d'un registre à décalage horizontal 8, 8' et d'un registre vertical 9, 9'. Le circuit de sortie comporte un convertisseur analogique-numérique 12, 12' destiné à convertir l'information analogique lue en une valeur numérique, disponible à la borne de sortie 14, 14'. Aux bornes d'entrée 15, 15' des circuits d'entrée 6, 6' des deux matrices 1 et 2 sont appliqués, respectivement, le signal analogique à échantillonner et le même signal mais en opposition de phase. Selon l'invention, il est avantageux de prévoir dans le circuit d'entrée par exemple 6' un élément à retard 17 d'une durée prédéterminée. Le retard pourrait être choisi égal à une demi-période de la fréquence d'échantillonnage d'un des circuits d'entrée ou canaux d'entrée 6, 6' isolés.

Comme l'indique encore la figure 1, chaque cellule mémoire représentée 3 de la matrice 1 comporte essentiellement un condensateur volant Cs de stockage des échantillons dont le circuit d'écriture comporte deux interrupteurs S1 et S2 reliés par une électrode respectivement au bus d'écriture 5 et au bus retour constituant le bus de référence 20, le condensateur Cs étant monté entre les deux autres électrodes des interrupteurs.

Le circuit de lecture du condensateur Cs est également monté entre deux interrupteurs de lecture S3 et S4. Une borne de l'interrupteur S3 est reliée à l'interconnexion entre le condensateur de stockage Cs et l'interrupteur S1, tandis que l'autre électrode est reliée à la sortie d'un amplificateur de lecture 21 qui est connectée à une borne du convertisseur analogique numérique 12. Concernant l'interrupteur S4, une électrode est reliée à l'interconnexion entre le condensateur CS et l'interrupteur S2. L'autre électrode est reliée à une entrée de l'amplificateur de lecture 21, l'autre entrée de celui-ci étant reliée au potentiel de référence 20. La figure 1 illustre encore une porte ET 22 montrée à titre d'exemple de la commande de l'interrupteur S1. La figure montre encore schématiquement qu'aux deux entrées de la porte ET 22 sont appliqués respectivement un signal de commande en provenance du registre horizontal 8 et un signal de commande produit par le registre vertical 9.

La cellule mémoire 3' de la matrice 2 comporte, de façon analogue à la cellule 3 de la matrice 1 un condensateur de stockage Cs' dont le circuit d'écriture comporte les interrupteurs S1' et S2' et le circuit de lecture les interrupteurs S3' et S4'. Les portes ET et l'amplificateur de lecture de la matrice 2 sont désignés par les références 22' et 21'.

Sur la figure 1 le système d'acquisition selon l'invention, qui sans l'élément à retard 17 présente une structure purement différentielle obtenue par l'association de deux réseaux distincts connectés en différentiel, est représenté sur la figure 2, en ce qui concerne les structures des cellules mémoire, sous forme d'une cellule différentielle. La structure permettant d'accéder à ces cellules élémentaires tant à l'écriture qu'à la lecture se compose d'un registre à décalage horizontal de par exemple 128 bascules utilisées en écriture et en lecture et d'un registre vertical droit de 20 bascules ainsi que d'un registre gauche de 20 autres bascules. Le registre droit est utilisé dans le processus de multiplexage de lecture. Les registres gauche et droit peuvent aussi être utilisés dans le processus de sous-échantillonage par masque, c'est-à-dire par masquage du pointeur d'écriture, nécessaire pour réduire la fréquence d'écriture. Les opérations d'écriture et de lecture sont cadencées par un signal d'horloge produit par un dispositif d'horloge non représenté.

Concernant la logique d'écriture, connue en soi, il suffit de rappeler que la matrice est parcourue par le pointeur d'écriture en colonne, en commençant par la colonne de gauche. Lorsque la première colonne a été parcourue, le pointeur de colonne est décalé d'un cran dans le registre horizontal afin de pointer sur la deuxième colonne etc, jusqu'à la dernière colonne. A l'initialisation, la première bascule du registre est donc positionnée à l'état logique 1 et toutes les autres à 0.

Dans chaque colonne, le pointeur est déplacé verticalement au sein d'un circuit du type DLL. Ce circuit permet d'obtenir des retards sous-multiples de la période d'horloge du système, ici par exemple de 1/20. Le pointeur vertical qui circule dans la DLL doit être d'une durée calibrée inférieure à la période d'horloge du système. Pour qu'une cellule soit écrite, il faut, comme cela a été indiqué plus haut, qu'elle se trouve à l'intersection d'une ligne et d'une colonne actives. Si le pointeur vertical fait 17ns de durée, alors à un instant donné 17 cellules sont en activité et à chaque ns le pointeur a progressé d'une cellule dans le sens vertical, d'où la fréquence d'écriture d'une ns pour une horloge système à 50 MHz dans cet exemple.

Concernant la logique de lecture, ce dispositif fait appel à un automate qui séquence toutes les opérations, à savoir la gestion des registres du pointeur et la commande des différents interrupteurs. Cette technique est connue en soi et n'a donc pas besoin d'être décrite plus en détail.

La cellule mémoire différentielle à double condensateurs volants comporte, supplémentairement à ce qui est montré sur la figure 1, deux amplificateurs suiveurs d'écriture 24, 24', qui sont montés en amont des interrupteurs S1 et S1'. Sur la figure 2 les deux cellules de mémoire élémentaires de la figure 1 sont maintenant reliées à la même référence 20. Entre le point de jonction des interrupteurs S2, S4 et du condensateur Cs et le point de jonction des interrupteurs S2', S4' et du condensateur Cs' peut être monté, optionnellement, un interrupteur SO qui permet d'optimiser la bande passante de la cellule en fonction de la dimension des interrupteurs S2, S2' et SO, avantageusement formé par des transistors interrupteurs.

Sur la figure 2 sont indiqués, à l'intérieur de rectangles en traits interrompus, de gauche à droite, le dispositif d'écriture d'une ligne, le dispositif de lecture d'une ligne et le dispositif de multiplexage des lignes.

Sur la figure 2, les amplificateurs de lecture 21, 21' se trouvent à l'intérieur du dispositif lecture d'une ligne et sont reliés aux interrupteurs de lecture S3, S4 et S3', S4' par l'intermédiaire d'interrupteurs respectivement S5, S6, S7 et S5', S6' et S7'. On constate que l'entrée négative de l'amplificateur 21 est relié à l'interrupteur S3 au moyen de l'interrupteur S5 et à l'interrupteur S4 au moyen de l'interrupteur S6. L'entrée positive est reliée à l'interrupteur S4 par l'intermédiaire de l'interrupteur S7. Cette description vaut de façon analogue pour l'amplificateur 21'.

Le dispositif de multiplexage comporte deux amplificateurs de sortie 26, 26' et vingt interrupteurs d'entrée de multiplexage montées en parallèle Sm0 à Sm19 et Sm0' à Sm19', susceptibles d'être reliés sélectivement à la sortie de l'amplificateur de sortie 21, 21' correspondant du dispositif de lecture d'une ligne.

En ce qui concerne le fonctionnement de la cellule selon la figure 2, les interrupteurs ayant les mêmes indices reçoivent la même commande logique. Ainsi, les interrupteurs S1 et S1' sont commandés simultanément. L'interrupteur So reçoit la même commande que l'interrupteur S2 et S2'. Comme indiqué précédemment, le signal d'entrée à échantillonner est appliqué à la borne d'entrée 15 et en opposition de phase à la borne d'entrée 15'. Il est relu sur les sorties 14 et 14'. Le signal de référence 20 pourrait être la masse.

On décrira ci-après le fonctionnement du système d'échantillonnage selon l'invention en se limitant à la moitié de la cellule, qui comporte le condensateur de stockage Cs, le fonctionnement de l'autre moitié étant identique puisque les structures des deux moitiés sont identiques.

La séquence d'écriture par échantillonnage du signal appliqué en entrée est réalisée par les interrupteurs S1 et S2. Pendant toute la phase d'écriture, les interrupteurs S3 et S4 restent ouverts et les interrupteurs S5 et S7 fermés. Les interrupteurs S1 et S2 sont simultanément fermés au début de l'échantillonnage. Ils restent fermés pendant toute la phase de l'échantillonnage. La fin de l'échantillonnage est réalisée par l'ouverture d'abord de l'interrupteur S2, suivie de celle de l'interrupteur S1 quelques nanosecondes plus tard. Le système de lecture d'une ligne est remis à zéro à chaque lecture. Les trois interrupteurs S5, S6, S7 sont utilisés pour la remise à zéro de l'amplificateur de lecture 21. Lors de la remise à zéro les interrupteurs S1, S2, S3 et S4 sont ouverts, les interrupteurs S5 et S7 sont fermés. L'amplificateur 21 est configuré en suiveur via un interrupteur S5. L'interrupteur S7 permet l'écoulement des charges résiduelles stockées sur la partie de bus 29 vers la référence. Après la remise à zéro la lecture de chaque cellule peut avoir lieu. Les interrupteurs S5 et S7 sont ouverts à la fin de la phase de remise à zéro et l'interrupteur S6 est fermé. Les interrupteurs S3 et S4 sont fermés afin de connecter le condensateur Cs en contre-réaction sur l'amplificateur 21.

La lecture est effectuée ligne par ligne afin de balayer toute la matrice. Les interrupteurs de multiplexage sont donc fermés tour à tour afin de sélectionner successivement toutes les lignes. A l'intérieur de chaque ligne, les différentes cellules, à savoir les 128 cellules dans l'exemple, sont successivement sélectionnées à l'aide des interrupteurs sus-mentionnés et la séquence de remise à zéro et de la lecture sera répétée autant de fois que nécessaire.

Le procédé selon l'invention, s'il prévoit un retard dans le canal 6' du signal d'entrée en opposition de phase au signal dans le canal 6 nécessite un algorithme de lecture modifié par rapport à une structure purement différentielle sans retard. En effet, si le retard est choisi égal à une demi-période de la fréquence d'échantillonnage, il y a maintenant deux fois plus d'échantillons à numériser et la suppression du mode commun n'est plus réalisable avec un amplificateur différentiel. Elle doit être faite par calcul après numérisation. Le décalage temporel apporté par l'élément à retard 17 équivaut à un système dans lequel les deux peignes d'échantillonnage sont entrelacés d'une demi-période, du fait que le retard pour l'intervalle d'échantillonnage est divisé par deux. On obtient ainsi le doublement de la fréquence d'échantillonnage effectif du système constitué.

La reconstitution du signal échantillonné se fait selon l'expression :

$$\mathtt{ECH\ (2i\ -\ 1)\ =\ ES(i)\ -\ ESI\ (i)\ +\ MS}$$

$$\mathtt{ECH\ (2i)\ =\ ES\ (i\ +\ 1)\ -\ ESI\ (i)\ +\ MS}$$

ou ECH (i) est l'échantillon du rang i, ES (i) est l'échantillon de rang i issu de la demi-matrice qui traite le signal non inversé, ESI (i + 1) est l'échantillon de rang i + 1 issu de la demi-matrice qui traite le signal inversé, MS est la mi-échelle des convertisseurs analogique-numérique, qui est égale à $2^{11}$ pour des convertisseurs analogique-numérique à douze chiffres binaires.

Grâce à cette reconstitution du signal échantillonné, l'invention permet d'éliminer efficacement le mode commun. On constate que la somme des échantillons décalés d'un indice, filtre le signal reconstitué.

Concernant la réalisation des différents interrupteurs, les interrupteurs S1 et S1' sont en technologie CMOS, tandis que les interrupteurs S2 à S7 et S2' à S7' sont en technologie NMOS.

La présente invention, en proposant une structure de cellules différentielles supprime les défauts des cellules simples à condensateur volant, qui résident dans la grande sensibilité du système au bruit de substrat, notamment des condensateurs formés par des transistors MOS à pistes métalliques, dans la pollution du signal enregistré par l'effet appelé "dropout" et dans un rapport signal sur bruit relativement faible. Concernant la pollution, les charges stockées dans les condensateurs mémoire s'échappent lentement via les fuites des interrupteurs d'où une erreur qui accroît avec la durée de rétention. Or cette rétention n'est pas la même pour les premières cellules lues que pour les dernières. Ce défaut est donc difficile à compenser par calcul. Le rapport signal sur bruit est limité par le bruit induit par les couplages capacitifs parasites avec les signaux numériques. La faible valeur du condensateur mémoire dictée par la bande passante recherchée conduit à une sensibilité non négligeable au bruits couplés.

Ces défauts ont tous un point en commun : ils s'expriment sur la sortie indépendamment du signal d'entrée. Pour supprimer les défauts, l'invention prévoit de dupliquer toute la matrice afin de constituer un système différentiel pour traiter deux signaux en opposition de phase. De la sorte, les distorsions seront vues comme du mode commun et élimine par la réjection du mode commun du dispositif de lecture. De plus, l'amplitude maximale du signal accessible est doublée, du fait du mode différentiel, par rapport à une solution simple. Donc même sans aucune réjection de mode commun, le rapport signal sur bruit est déjà amélioré de 6 dB. La réjection du mode commun est d'autant plus efficace vis-à-vis des signaux parasites que les deux structures sont symétriques. Dans cet objectif, la réalisation de la matrice avec des cellules mémoire élémentaires différentielles est particulièrement avantageuse.

Concernant le système à retard, il présente des avantages de procurer un doublement de la fréquence d'échantillonnage et un doublement de la capacité mémoire sans dégradation notable du rapport signal/bruit.

## Revendications

**1.** Système d'acquisition d'un signal analogique par échantillonnage, du type comportant une matrice de cellules mémoires analogiques agencées en une pluralité de lignes et de colonnes, chaque cellule étant reliée à un bus d'écriture et un bus de lecture et comportant deux entrées de signaux de commande d'activation, lesdits signaux obtenus à partir d'un signal d'horloge, un registre à décalage horizontal et un registre vertical destinés à appliquer aux cellules des signaux de commande d'activation pour les opérations d'écriture et de lecture des cellules, **caractérisé en ce que** le bus d'écriture et le bus de lecture comportent chacun deux canaux (4, 4' ; 5, 5'), que l'un (4') des deux canaux du bus d'écriture reçoit le signal analogique à échantillonner en opposition de phase par rapport à l'autre canal (4); **en ce que** chaque cellule mémoire (3) comporte, sous forme d'une structure différentielle, deux dispositifs mémoires chacun relié à l'un des deux canaux (4, 4') du bus d'écriture et du bus de lecture (5, 5'); et **en ce que** le système présente une structure différentielle, comportant deux entrées (15, 15') recevant respectivement le signal analogique à échantillonner et le signal analogique à échantillonner en opposition de phase

2. Système selon la revendication 1, **caractérisé en ce que** le circuit d'entrée (6') de l'un (4') des deux canaux de bus d'écriture comporte un élément à retard (17), avantageusement d'une durée correspondante à une demi-période de la fréquence d'échantillonnage.

3. Système selon l'une des revendications 1 et 2, **caractérisé en ce que** chaque dispositif mémoire d'une cellule mémoire comporte un condensateur de stockage (Cs, Cs'), monté flottant dans un circuit d'écriture entre le bus d'écriture (4, 4') et un potentiel de références (20, 20') et un circuit de lecture entre le bus de lecture (5, 5') et ledit potentiel de référence, les deux circuits comportant des interrupteurs susceptibles d'être commandés sélectivement.

4. Système selon la revendication 3, **caractérisé en ce que** le condensateur de stockage (Cs, Cs') est disposé dans le circuit d'écriture entre deux interrupteurs (S1, S1' ;S2, S2').

5. Système selon la revendication 3 **caractérisé en ce que** le condensateur de stockage (Cs, Cs') est monté dans le circuit de lecture entre deux interrupteurs (S3, S3' ; S4, S4').

6. Système selon l'une des revendications 3 à 5, **caractérisé en ce qu'**une cellule mémoire est réalisée sous forme d'une cellule différentielle, dans laquelle le potentiel de référence (20) est commun aux deux dispositifs mémoire. 5

7. Système selon la revendication 5, **caractérisé en ce que** les deux condensateurs de stockage (Cs ; Cs') sont reliés par un interrupteur optionnel (SO) d'élargissement de la bande passante de la cellule.

8. Système selon l'une des revendications 1 à 7, **caractérisé en ce qu'**il comporte un dispositif de reconstitution du signal échantillonné par calcul après numérisation.

9. Système selon l'une des revendications 2 à 8, **caractérisé en ce que** l'élément à retard introduit un décalage temporel afin d'obtenir un doublement de la fréquence d'échantillonnage effectif du système constitué.

**Claims**

1. System, for the acquisition of analog signals by means of sampling, of the kind comprising a matrix of analog memory cells arranged in a number of lines and columns, each cell being connected to a read bus and a write bus and having two activation control input signals, these being obtained from a clock signal, a horizontal shift register and a vertical register for applying activation control signals to the cells for the read and write operations, **characterized in that** the read bus and the write bus each comprise two channels (4, 4' ; 5, 5'), **in that** one (4') of the two channels of the write bus receives the analog signal to be sampled in a phase opposite to that of the other channel (4); **in that** each memory cell (3) comprises, in the form of a differential structure, two memory devices, each connected to one of the two channels (4, 4') of the read bus and of the write bus (5, 5'); and **in that** the system has a differential structure having two inputs (15, 15') respectively receiving the analog signal to be sampled and the analog signal, to sample, in an opposite phase.

2. System in accordance with claim 1, **characterized in that** the input circuit (6') of one (4') of the two write bus channels has a delay element (17) favourably with a delay corresponding to a semi-oscillation of the sampling frequency.

3. System in accordance with one of claims 1 and 2, **characterized in that** each memory device of a memory cell has a storage capacitor (Cs, Cs') mounted floating in a write circuit between the write bus (4, 4') and reference voltage (20, 20') and a read circuit between the read bus (5, 5') and the said reference voltage, the two circuits having circuit breakers that can be selectively controlled.

**4.** System in accordance with claim 3, **characterized in that** the storage capacitor (Cs, Cs') is in the write circuit, between two circuit breakers (S1, S1' ; S2, S2').

**5.** System in accordance with claim 3, **characterized in that** the storage capacitor (Cs, Cs') is mounted in the read circuit, between two circuit breakers (S3, S3' ; S4, S4').

**6.** System in accordance with one of claims 3 to 5, **characterized in that** one memory cell is implemented as a differential cell, in which the reference voltage (20) is common to the two memory devices.

**7.** System in accordance with claim 5, **characterized in that** the two storage capacitors (Cs, Cs') are connected by an optional circuit breaker (OC) extending the pass-range of the cell.

**8.** System in accordance with one of claims 1 to 7, **characterized in that** it has a device for re-constituting the signal sampled by computation following digitization.

**9.** System in accordance with one of claims 2 to 8, **characterized in that** the delay element introduces a time shift in order to double the effective sampling frequency of the system set up.

**Patentansprüche**

**1.** System zur Erfassung eines analogen Signals mittels Abtastung, des Typs, der eine Matrix analoger Speicherzellen, die in einer Vielzahl von Reihen und Spalten angeordnet sind, umfasst, wobei jede Zelle mit einem Schreibbus und einem Lesebus verbunden ist und zwei Eingänge für Aktivierungsbefehl-Signale umfasst, wobei die Signale ausgehend von einem Taktsignal, einem horizontalen Schieberegister und einem vertikalen Register erhalten werden, die dazu bestimmt sind, Aktivierungsbefehl-Signale für die Arbeitsgänge des Schreibens und Lesens der Zellen an die Zellen anzulegen, **dadurch gekennzeichnet, dass** der Schreibbus und der Lesebus je zwei Kanäle (4, 4'; 5, 5') umfassen, wobei der eine (4') der beiden Kanäle des Schreibbusses das analoge Tastsignal im Vergleich zum anderen Kanal (4) phasenversetzt empfängt; **dadurch**, dass jede Speicherzelle (3) zwei Speichervorrichtungen in Form einer differentiellen Struktur umfasst, wobei jede mit einem der beiden Kanäle (4, 4') des Schreibbusses und des Lesebusses (5, 5') verbunden ist; und **dadurch**, dass das System eine differentielle Struktur aufweist, umfassend zwei Eingänge (15, 15'), die je das analoge Tastsignal und das phasenversetzte analoge Tastsignal empfangen.

**2.** System nach Anspruch 1, **dadurch gekennzeichnet, dass** die Eingangsschaltung (6') des einen (4') der beiden Kanäle des Schreibbusses ein Verzögerungselement (17) umfasst, zweckmäßigerweise mit einer Dauer, die einer halben Periode der Tastfrequenz entspricht.

**3.** System nach einem der Ansprüche 1 und 2, **dadurch gekennzeichnet, dass** jede Speichervorrichtung einer Speicherzelle einen Speicherkondensator (Cs, Cs') umfasst, schwimmend in einer Schreibschaltung zwischen dem Schreibbus (4, 4') und einem Verweispotential (20, 20') montiert und einer Leseschaltung zwischen dem Lesebus (5, 5') und dem Verweispotential, wobei die beiden Schaltungen zur selektiven Steuerung geeignete Schalter umfassen.

**4.** System nach Anspruch 3, **dadurch gekennzeichnet, dass** der Speicherkondensator (Cs, Cs') in der Schreibschaltung zwischen zwei Schaltern (S1, S1'; S2, S2') angeordnet ist.

**5.** System nach Anspruch 3, **dadurch gekennzeichnet, dass** der Speicherkondensator (Cs, Cs') in der Leseschaltung zwischen zwei Schaltern (S3, S3'; S4, S4') montiert ist.

**6.** System nach einem der Ansprüche 3 bis 5, **dadurch gekennzeichnet, dass** eine Speicherzelle in Form einer differentiellen Zelle umgesetzt ist, in der das Verweispotential (20) den beiden Speichervorrichtungen gemein ist.

**7.** System nach Anspruch 5, **dadurch gekennzeichnet, dass** die beiden Speicherkondensatoren (Cs; Cs') mittels eines optionalen Vergrößerungsschalters (SO) der Durchlassbreite der Zelle miteinander verbunden sind.

**8.** System nach einem der Ansprüche 1 bis 7, **dadurch gekennzeichnet, dass** es eine Vorrichtung zur Wiederherstellung des abgetasteten Signals mittels Berechnung nach der Digitalisierung umfasst.

9. System nach einem der Ansprüche 2 bis 8, **dadurch gekennzeichnet, dass** das Verzögerungselement eine temporäre Verschiebung einführt, um eine Verdoppelung der effektiven Tastfrequenz des dargestellten Systems zu erhalten.

Fig. 1

Fig. 2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4271488 A

- JP 11283394 A